# EUROPÄISCHE PATENTSCHRIFT

(11) **EP 3 213 344 B1**
(45) Veröffentlichungstag und Bekanntmachung des Hinweises auf die Patenterteilung: **30.01.2019**
(21) Anmeldenummer: 15766449.1
(22) Anmeldetag: 16.09.2015
(51) Int. Cl.: H01L 23/495, H01L 23/492, H01L 25/07

(54) **ANSCHLUSSRAHMEN FÜR EIN HALBLEITERBAUELEMENT, SCHALTUNGSANORDNUNG MIT EINEM ANSCHLUSSRAHMEN**
LEADFRAME FOR A SEMICONDUCTOR COMPONENT, CIRCUIT ARRANGEMENT COMPRISING A LEADFRAME
CADRE DE RACCORDEMENT POUR UN COMPOSANT SEMI-CONDUCTEUR, DISPOSITIF DE CIRCUIT AVEC UN CADRE DE RACCORDEMENT

(30) Priorität: 31.10.2014 DE 102014222334
(43) Veröffentlichungstag der Anmeldung: 06.09.2017
(73) Patentinhaber: Conti Temic microelectronic GmbH, 90411 Nürnberg (DE)
(72) Erfinder: POLA, Olivier, 31500 Toulouse (DE); WALK, Michael, 92367 Pilsach (DE)
(74) Vertreter: Bonn, Roman Klemens
(86) Internationale Anmeldenummer: PCT/EP2015/071221
(87) Internationale Veröffentlichungsnummer: WO 2016/066320

(56) Entgegenhaltungen:
- GB-A- 1 058 541
- JP-A- S5 484 477
- JP-A- S55 150 246
- JP-A- 2003 046 058
- US-A1- 2002 190 374

## Beschreibung

Die vorliegende Erfindung betrifft einen Anschlussrahmen für zumindest ein Halbleiterbauelement und eine Schaltungsanordnung mit zumindest einem genannten Anschlussrahmen.

Es gibt Schaltungsanordnungen mit Anschlussrahmen (auf Englisch "leadframe"), die bspw. aus gestanzten Metallblechen bestehen und als lötbare metallische Schaltungsträger zur mechanischen Befestigung von Halbleiterbauelementen, insb. von Nacktchips (gehäuselosen Halbleiterchips), sowie zur Herstellung elektrischer Verbindungen zu diesen Halbleiterbauelementen ausgebildet sind. Die Halbleiterbauelemente werden direkt auf den Anschlussrahmen gelötet und über die Lötverbindungen mit den Anschlussrahmen direkt elektrisch verbunden. Elektrische Verbindungen von diesen Halbleiterbauelementen zu den elektrischen Komponenten der Schaltungsanordnungen außerhalb der Anschlussrahmen werden in der Regel über Bondverbindungen hergestellt (Chipbonden).

Eine Druckschrift GB 1 058 541 A beschreibt einen Anschlussrahmen für ein Halbleiterbauelement. Der Anschlussrahmen umfasst eine Aussparung, ein elektrisch leitendendes Anschlusselement in der Aussparung zur Herstellung elektrischer Verbindung zu dem Halbleiterbauelement, sowie ein Isolierelement in der Aussparung, der das Anschlusselement von dem Anschlussrahmen elektrisch isoliert.

Eine weitere Druckschrift JP S54 84477 A beschreibt eine Halbleitervorrichtung mit Kontaktpins, die in mit Glasisolatoren versehenden Aussparungen einer Halbleiterbasis der Halbleitervorrichtung angeordnet sind.

Eine weitere Druckschrift JP S55 150246 A beschreibt ein Halbleiterchip mit isolierten Elektrodenanschlüssen.

Eine weitere Druckschrift US 2002/190374 A1 beschreibt eine Leistungshalbleitervorrichtung mit Anschlusselektroden.

Eine weitere Druckschrift JP 2003 046058 A beschreibt eine Halbleitervorrichtung mit Steueranschlüssen, die senkrecht zu einem gemeinsamen Träger der Halbleitervorrichtung gesteckt sind.

Aufgrund der Anfälligkeit gegenüber Erschütterungen und Materialalterungen sind die Bondverbindungen eine der Hauptursachen für die Ausfälle der Schaltungsanordnungen.

Außerdem nehmen Steueranschlüsse von Schaltungsanordnungen einen zusätzlichen Bauraum in Anspruch und machen zudem die Schaltungsanordnungen komplexer.

Damit besteht die Aufgabe der vorliegenden Erfindung darin, die Schaltungsanordnungen, insb. hinsichtlich der Zuverlässigkeit, der Baugröße bzw. der Baukosten, besser zu machen.

Diese Aufgabe wird durch Gegenstände der unabhängigen Ansprüche gelöst. Vorteilhafte Ausgestaltungen sind Gegenstand der Unteransprüche.

Gemäß einem ersten Aspekt der Erfindung wird ein Anschlussrahmen für ein Halbleiterbauelement bereitgestellt. Der Anschlussrahmen umfasst eine Aussparung, die durchgehend oder auch nicht durchgehend geformt ist. Der Anschlussrahmen umfasst ferner ein elektrisch leitendes Anschlusselement zur Herstellung elektrischer Verbindung zu dem Halbleiterbauelement. Das Anschlusselement ist dabei (zumindest teilweise) in der Aussparung angeordnet. Der Anschlussrahmen umfasst ferner ein Isolierelement, das ebenfalls in der Aussparung angeordnet ist und das Anschlusselement mit dem Anschlussrahmen mechanisch verbindet und zugleich von dem Anschlussrahmen elektrisch isoliert. Das Isolierelement weist einen (im Wesentlichen) zylinderförmigen Hohlraum auf, in dem ein Einlegeelement angeordnet ist, das das Isolierelement und das Anschlusselement miteinander mechanisch verbindet.

Dabei ist der Anschlussrahmen insb. elektrisch leitend ausgebildet und besteht vorzugsweise aus einem Metall oder einer Metalllegierung, wie z. B. Kupfer, einer Kupfer- oder Aluminiumlegierung.

Der Erfindung liegt die Erkenntnis zugrunde, dass die Bondverbindung, welche die auf den Anschlussrahmen angeordneten Halbleiterbauelementen mit außerhalb vom Anschlussrahmen befindlichen Schaltungskomponenten der Schaltungsanordnungen elektrisch verbinden und somit sich über weite Distanzen spannen, aufgrund der Erschütterungen der Schaltungsanordnung und der damit verbundenen mechanischen Schwingungen zwischen dem Anschlussrahmen und den externen Schaltungskomponenten starken mechanischen Beanspruchungen ausgesetzt sind. Diese mechanischen Beanspruchungen führen dazu, dass die Bondverbindungen schnell altern und somit zu Bruch gehen bzw. sich von den Kontaktstellen lösen.

Zudem beanspruchen derartige Bondverbindungen sowie entsprechende Anschlüsse zur Herstellung elektrischer Verbindungen von den Bondverbindungen zu den externen Schaltungskomponenten einen nicht unwesentlichen Bauraum, was wiederum negativ auf die Baugröße der Schaltungsanordnung auswirkt.

Um die oben aufgelisteten Nachteile zu vermeiden, wurde im Rahmen dieser Erfindung der oben beschriebene Anschlussrahmen weiterentwickelt, wobei die elektrischen Verbindungen von dem Anschlussrahmen bzw. von den auf dem Anschlussrahmen ange ordneten Halbleiterbauelementen über die elektrisch leitenden Anschlusselemente hergestellt werden, die mechanisch wesentlich stabiler als die zuvor genannten Bondverbindungen sind und zudem wesentlich kompakter als die zuvor genannten Anschlüsse zur Herstellung elektrischer Verbindungen von den Bondverbindungen zu den externen Schaltungskomponenten, die in der Regel am Rand der Anschlussrahmen geschweißt werden.

Dabei können die Anschlusselemente einen Einpresspin (auf Englisch "Press-fit pin") umfassen bzw. als ein Einpresspin ausgebildet sein. Die elektrischen Verbindungen von dem Anschlussrahmen bzw. von den Halbleiterbauelementen zu den außerhalb von dem Anschlussrahmen befindlichen Schaltungskomponenten können über diese stabileren Anschlusselemente hergestellt werden. Die unmittelbaren elektrischen Verbindungen von den Halbleiterbauelementen zu den auf demselben Anschlussrahmen angeordneten Anschlusselementen können weiterhin mittels der Bondverbindungen hergestellt werden, die sich über kurze Distanzen zu spannen brauchen und somit wesentlich stabiler und schwingungsresistenter sind. Zudem sind diese Bondverbindungen nicht den mechanischen Beanspruchungen ausgesetzt, die durch die mechanischen Schwingungen zwischen dem Anschlussrahmen und den externen Schaltungskomponenten verursacht werden. Damit sind die Schaltungsanordnungen stabiler und zuverlässiger.

Die Anschlusselemente (bspw. Einpresspins) können zudem auf dem Anschlussrahmen flexibel überall dort positioniert werden, wo freie Bauräume, wie z. B. Zwischenräume zwischen zwei Schaltungskomponenten auf dem Anschlussrahmen, zur Verfügung stehen. Dadurch können die vorhandenen Bauräume effektiver ausgenutzt werden und folglich kann die Baugröße der Schaltungsanordnungen reduziert werden. Zudem lässt sich die Komplexität der Anschlussrahmen dank der oben genannten Flexibilität reduzieren. Da die Anschlusselemente zudem relativ frei dimensioniert werden können, können diese auch niederinduktiv ausgebildet werden. Damit ist eine, insb. hinsichtlich der Zuverlässigkeit, der Baugröße bzw. der Baukosten, bessere Schaltungsanordnung geschaffen.

Vorzugsweise ist das Einlegeelement elektrisch leitend ausgeführt, um das Halbleiterbauelement mit dem Anschlusselement elektrisch verbinden zu können.

Das Isolierelement umfasst ferner einen Bodenbereich, der den Hohlraum des Isolierelements einseitig abschließt und das Anschlusselement von dem Anschlussrahmen elektrisch isoliert.

Der Bodenbereich kann bspw. aus einem Kunststoff bestehen und dient zum Schutz des Anschlussrahmens vor einer mechanischen Beschädigung durch das Anschlusselement und zur Einhaltung einer minimalen Kriechstromdistanz zwischen dem stromführenden Anschlusselement und dem elektrisch leitenden und ggfs. ebenfalls stromführenden Anschlussrahmen.

Das Einlegeelement ummantelt vorzugsweise einen (im Wesentlichen) zylinderförmigen Hohlraum, in dem das Anschlusselement zumindest teilweise angeordnet ist und mit dem Einlegeelement elektrisch leitend und mechanisch verbunden ist. Insb. ist das Anschlusselement mit dem Einlegeelement form- und/oder kraftschlüssig verbunden.

Das Einlegeelement umfasst einen zylindermantelförmigen Abschnitt, der den zylinderförmigen Hohlraum ummantelt, und eine sich daran anschließende, in radialer Richtung weisende Anformung, die eine elektrisch leitende Kontaktfläche aufweist, die zur elektrischen Kontaktierung einer Bondverbindung von dem Einlegeelement zu dem Halbleiterelement dient.

Gemäß einem weiteren Aspekt der Erfindung wird eine Schaltungsanordnung bereitgestellt. Die Schaltungsanordnung umfasst zumindest ein Halbleiterbauelement und zumindest einen zuvor beschriebenen Anschlussrahmen, wobei das zumindest eine Halbleiterbauelement auf der Oberfläche des zumindest einen Anschlussrahmen angeordnet ist und über eine Bondverbindung mit dem Anschlusselement des zumindest einen Anschlussrahmens elektrisch verbunden ist.

Vorzugsweise umfasst die Schaltungsanordnung zumindest zwei Anschlussrahmen, die jeweils zum Tragen von zumindest einem Halbleiterbauelement und zur Herstellung von elektrischer Verbindung zu diesem zumindest einen Halbleiterbauelement ausgebildet sind. Dabei sind die beiden Anschlussrahmen insb. elektrisch leitend ausgebildet und bestehen vorzugsweise aus einem Metall oder einer Metalllegierung, wie z. B. Kupfer, einer Kupfer- oder einer Aluminiumlegierung.

Die beiden Anschlussrahmen weisen jeweils eine Aussparung auf. Die beiden Aussparungen erstrecken sich vorzugsweise im Wesentlichen schlitzförmig bis zu einem Rand der jeweiligen Anschlussrahmen.

Die Schaltungsanordnung umfasst ferner ein elektrisch leitendendes Anschlusselement zur Herstellung elektrischer Verbindung zu den zumindest zwei Halbleiterbauelementen, die auf den Oberflächen der jeweiligen Anschlussrahmen verteilt angeordnet sind. Das Anschlusselement ist dabei vorzugsweise im Wesentlichen stabförmig ausgebildet und in einer der beiden Aussparungen angeordnet.

Die Schaltungsanordnung umfasst ferner ein elektrisch isolierendes Isolierelement, das in den beiden Aussparungen der zumindest zwei Anschlussrahmen angeordnet ist und sich von einer der beiden Aussparungen zu der anderen der beiden Aussparungen erstreckt. Das Isolierelement isoliert das Anschlusselement von den zumindest zwei Anschlussrahmen elektrisch und verbindet vorzugsweise zugleich das Anschlusselement und die zumindest zwei Anschlussrahmen körperlich bzw. mechanisch miteinander.

Vorteilhafte Ausgestaltungen des oben beschriebenen Anschlussrahmens sind, soweit im Übrigen auf die zuvor genannte Schaltungsanordnung übertragbar, auch als vorteilhafte Ausgestaltungen der Schaltungsanordnung anzusehen.

Im Folgenden wird eine beispielhafte Ausführungsform der Erfindung bezugnehmend auf die beiliegenden Zeichnungen näher erläutert. Dabei zeigen:
- Figur 1: in einer schematischen Vogelperspektivdarstellung einen Abschnitt einer Schaltungsanordnung gemäß einer Ausführungsform der Erfindung;
- Figur 2: in einer schematischen Darstellung einen seitlichen Abschnitt der in Figur 1 dargestellten Schaltungsanordnung entlang einer Schnittlinie AA;
- Figur 3: in einer schematischen Draufsicht einen Abschnitt einer Schaltungsanordnung gemäß einer weiteren Ausführungsform der Erfindung.

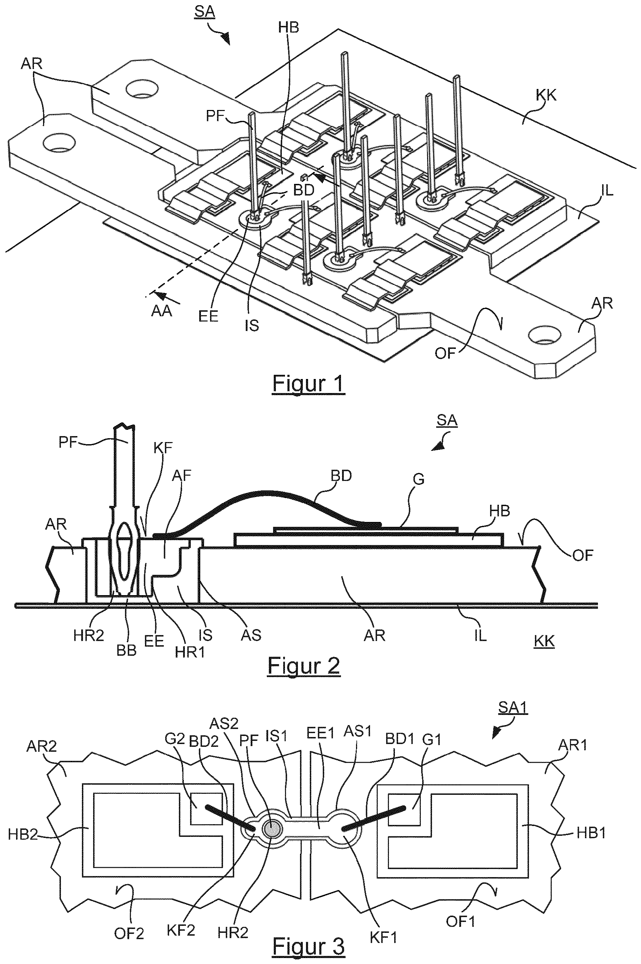

Figur 1 zeigt einen Abschnitt einer Schaltungsanordnung SA eines Inverters zur Bereitstellung von Phasenströmen für einen in der Figur nicht dargestellten Elektromotor in einer schrägen Vogelperspektivdarstellung.

Die Schaltungsanordnung SA umfasst drei Anschlussrahmen AR, die nebeneinander auf einem Kühlkörper KK angeordnet sind und über eine Isolationsschicht IL von dem Kühlkörper KK elektrisch isoliert sind.

Die Anschlussrahmen AR sind jeweils aus einem Metallblech gestanzt und sind somit elektrisch leitend. Auf jeweiligen von dem Kühlkörper KK abgewandten Oberflächen OF von zwei der drei Anschlussrahmen AR sind jeweils drei Halbleiterschalter HB angeordnet und jeweils über eine Lötfläche mit den jeweiligen Anschlussrahmen AR elektrisch leitend und mechanisch verbunden.

Dabei sind die Halbleiterschalter HB als gehäuselose MOSFET's (Metall-Oxid-Halbleiter-Feldeffekttransistor, Nacktchips) ausgebildet und über die jeweiligen Source-Anschlüsse auf den Oberflächen OF der jeweiligen Anschlussrahmen AR oberflächenkontaktiert und mit den jeweiligen Anschlussrahmen AR elektrisch verbunden.

Auf den gleichen Oberflächen OF dergleichen beiden Anschlussrahmen AR sind ferner Einpresspins PF (Anschlusselemente) angeordnet, die jeweils in einer dafür vorgesehenen Aussparung AS auf der Oberfläche OF der jeweiligen Anschlussrahmen AR eingepresst sind.

Die Einpresspins PF sind als metallischen Pins bspw. aus einem Metalldraht, wie z. B. einem Kupferdraht, ausgebildet.

Ein Abschnitt der Aussparung AS samt dem darin angeordneten Einpresspin PF ist in Figur 2 detailliert dargestellt. Dabei zeigt Figur 2 einen seitlichen Querschnitt eines der Anschlussrahmen AR entlang der Querschnittlinie AA in Figur 1.

Wie in Figur 2 klar zu erkennen ist, weist der Anschlussrahmen AR auf der Oberfläche OF eine durchgehende zylinderförmige Aussparung AS auf, in der ein Isolierelement IS angeordnet und mechanisch (kraftschlüssig) befestigt ist.

Das Isolierelement IS besteht aus einem elektrisch isolierenden Material, wie z.B. Kunststoff, und ist im Wesentlichen hohlzylinderförmig ausgebildet und umfasst einen im Wesentlichen zylinderförmigen Hohlraum HR1. Das Isolierelement IS weist einen Bodenbereich BB, der den Hohlraum HR1 einseitig abschließt und von der unter dem Anschlussrahmen AR liegenden Isolierschicht IL räumlich trennt.

In dem Hohlraum HR1 des Isolierelements IS ist ein Einlegeelement EE aus einem Metall oder einer Metalllegierung, wie z. B. einer Aluminiumlegierung, angeordnet und bspw. durch Einpressen, Fügen oder Umspritzen in den Hohlraum HR1 mit dem Isolierelement IS bzw. dem Anschlussrahmen AR mechanisch (kraftschlüssig) verbunden. Das Einlegeelement EE besteht aus einem elektrisch leitenden Material, wie z.B. Kupfer oder einer Kupferlegierung, und weist eine Form auf, die der Form des Hohlraums HR1 des Isolierelements IS angepasst ist.

Das Einlegeelement EE umfasst einen im Wesentlichen hohlzylinderförmigen Rundkörper, der einen zylinderförmigen Hohlraum HR2 mantelförmig umschließt. Das Einlegeelement EE umfasst ferner eine Anformung AF, die sich von dem Hohlraum HR2 des Einlegeelements EE weg radial erstreckend an dem Rundkörper des Einlegeelements EE angeformt ist. Die Anformung AF weist eine Kontaktfläche KF auf, auf der eine Bonddraht BD aufgelötet und somit mit dem Einlegeelement EE elektrisch kontaktiert ist. Die Bonddraht BD ist ferner auf einer Kontaktfläche des auf der Oberfläche OF des Anschlussrahmens AR befindlichen Halbleiterschalters HB aufgelötet und verbindet somit den Halbleiterschalter HB mit dem Einlegeelement EE elektrisch.

In dem Hohlraum HR2 des Einlegeelements EE ist der Einpresspin PF eingepresst, wobei dieser beim Einpressen in den Hohlraum HR2 sich verformt hat und somit mit dem Einlegeelement EE form- bzw. kraftschlüssig stabil verbunden ist (Pressfitverbindung). Der Bonddraht BD erstreckt sich somit von dem Halbleiterschalter HB zu dem Einlegeelement EE und verbindet den Gate-Anschluss des Hableiterschalters HB mit dem Einlegeelement EE bzw. dem Einpresspin PF elektrisch.

Dabei sind sowohl der Hableiterschalter HB zu das Einlegeelement EE auf der gleichen Oberfläche OF desselben Anschlussrahmens AR und somit zueinander bewegungsfest und schwingungsfrei anordnet. Dadurch wird der Bonddraht BD vor mechanischen Beanspruchungen geschont, welche durch mechanische Schwingungen zwischen dem Anschlussrahmen und den externen Schaltungskomponenten verursacht werden. Folglich altert der Bonddraht BD langsamer als ein Bonddraht einer anfangs genannten Bondverbindung.

Zudem lässt sich die Aussparung AS samt dem Einpresspin PF flexibel an einem Ort des Anschlussrahmens AR platzieren, wo schaltungstechnisch am besten geeignet ist und den Bauraum der Schaltungsanordnung SA am wenigsten beansprucht. Dadurch kann die Schaltungsanordnung SA bauraumsparender und mit einer geringen Komplexität gebaut werden.

Die Pressfitverbindung des Einpresspins PF mit dem Anschlussrahmen AR ist im Vergleich zu einer Ultraschall-geschweißten Verbindung einfacher und kostengünstiger herstellbar.

Figur 3 zeigt in einer schematischen Draufsicht einen Abschnitt einer weiteren Schaltungsanordnung SA1 mit einem ersten Anschlussrahmen AR1 und einem zweiten Anschlussrahmen AR2, die nebeneinander angeordnet sind. Die beiden Anschlussrahmen AR1, AR2 bestehen aus jeweils einem gestanzten Metallblech und sind somit elektrisch leitend.

Auf jeweiliger Oberfläche OF1, OF2 der jeweiligen gleichen, dem Betrachter der Figur zugewandten Seiten weisen die beiden Anschlussrahmen AR1, AR2 jeweils eine Aussparung AS1, AS2 auf, die jeweils sich schlitzförmig bis zu einem Rand der jeweiligen Anschlussrahmen AR1, AR2 und in jeweils zueinander zugewandte Richtung erstrecken.

Die Schaltungsanordnung SA1 umfasst ferner ein Einlegeelement EE1 aus einer elektrisch leitenden Metalllegierung, das im Wesentlichen hantelförmig ausgebildet ist. Das Einlegeelement EE1 ist in den beiden Aussparungen AS1, AS2 angeordnet und erstreckt sich von einer der beiden Aussparungen AS1 zu der anderen Aussparung AS2. Dadurch verbindet das Einlegeelement EE1 die beiden Anschlussrahmen AR1, AR2 körperlich und mechanisch miteinander.

Das Einlegeelement EE1 greift in die beiden Aussparungen AS1, AS2 formschlüssig ein. Die beiden Aussparungen AS1, AS2 weisen Hinterschneidungen auf, in die insb. das Einlegeelement EE1 formschlüssig eingreift.

Das Einlegeelement EE1 ist mit den beiden Anschlussrahmen AR1, AR2 mittels eines Isolierelements IS1 mechanisch verbunden, das zwischen dem Einlegeelement EE1 und der Innenwand der beiden Aussparungen AS1, AS2 angeordnet ist und das Einlegeelement EE1 mit den beiden Anschlussrahmen AR1, AR2 körperlich und mechanisch verbindet und zugleich von den beiden Anschlussrahmen AR1, AR2 elektrisch isoliert.

Das Einlegeelement EE1 weist an beiden Enden jeweils eine plane Kontaktfläche KF1, KF2 auf, die zur Herstellung elektrischer Verbindungen ausgebildet sind.

An einem Endbereich weist das Einlegeelement EE1 zudem eine im Wesentlichen zylinderförmige Ausnehmung, die einen Hohlraum HR2 zur Aufnahme und zur mechanischen Befestigung (Pressfitverbindung) eines Einpresspins ausbildet ist.

Die Schaltungsanordnung SA1 umfasst ferner einen Einpresspin PF aus einem Kupferdraht, der in dem Hohlraum HR2 des Einlegeelements EE1 in einem Pressfit-Vorgang eingepresst ist. Der Einpresspin PF dient zur Herstellung elektrischer Verbindung von dem Einlegeelement EE1 zu externen Schaltungskomponenten.

Die Schaltungsanordnung SA1 umfasst ferner zwei gehäuselosen MOSFET's HB1, HB2 (Nacktchips), die jeweils auf den jeweiligen Oberflächen OF1, OF2 der beiden Anschlussrahmen AR1, AR2 angeordnet und über den jeweiligen Source-Anschluss (in der Figur nicht sichtbar) mittels Lötverbindung mit den jeweiligen Anschlussrahmen AR1, AR2 oberflächenkontaktiert sind.

Die beiden MOSFET's HB1, HB2 sind ferner über den jeweiligen Gate-Anschluss G1, G2 und mittels jeweils einer Bondverbindung BD1, BD2 mit dem Einlegeelement EE1 und somit mit dem Einpresspin PF elektrisch verbunden. Dabei überspannen die beiden Bondverbindungen BD1, BD2 zwischen den jeweiligen Gate-Anschlüssen und jeweiligen entsprechenden Kontaktflächen KF1, KF2 des Einlegeelements EE1.

## Patentansprüche

1. Anschlussrahmen (AR, AR2) für ein Halbleiterbauelement (HB), umfassend:
- eine Aussparung (AS, AS2);
- ein elektrisch leitendendes Anschlusselement (PF) zur Herstellung elektrischer Verbindung zu dem Halbleiterbauelement (HB, HB2), das in der Aussparung (AS, AS2) angeordnet ist;
- ein Isolierelement (IS, IS1), das in der Aussparung (AS, AS2) angeordnet ist und das Anschlusselement (PF) mit dem Anschlussrahmen (AR, AR2) mechanisch verbindet und von dem Anschlussrahmen (AR, AR2) elektrisch isoliert,
**dadurch kennzeichnet, dass**
- das Isolierelement (IS) einen zylinderförmigen Hohlraum (HR1) aufweist, in dem ein Einlegeelement (EE) angeordnet ist, das das Isolierelement (IS) und das Anschlusselement (PF) miteinander mechanisch verbindet.

2. Anschlussrahmen (AR) nach Anspruch 1, wobei das Einlegeelement (EE) elektrisch leitendend ausgeführt ist.

3. Anschlussrahmen (AR) nach Anspruch 1 oder 2, wobei das Isolierelement (IS) einen Bodenbereich (BB) umfasst, der den Hohlraum (HR1) einseitig abschließt und das Anschlusselement (PF) von dem Anschlussrahmen (AR) elektrisch isoliert.

4. Anschlussrahmen (AR) nach einem der Ansprüche 1 bis 3, wobei das Einlegeelement (EE) einen zylinderförmigen Hohlraum (HR2) ummantelt, in dem das Anschlusselement (PF) angeordnet ist und mit dem Einlegeelement (EE) elektrisch und mechanisch verbunden ist.

5. Anschlussrahmen (AR) nach Anspruch 4, wobei das Anschlusselement (PF) mit dem Einlegeelement (EE) form- und/oder kraftschlüssig verbunden ist.

6. Anschlussrahmen (AR) nach Anspruch 4 oder 5, wobei das Einlegeelement (EE) eine sich von dem zylinderförmigen Hohlraum (HR2) weg erstreckende Anformung (AF) mit einer elektrisch leitenden Kontaktfläche (KF) zur Herstellung einer Bondverbindung (BV) von dem Einlegeelement (EE) zu dem Halbleiterbauelement (HB) umfasst.

7. Schaltungsanordnung (SA, SA1) umfassend zumindest ein Halbleiterbauelement (HB, HB2) und zumindest einen Anschlussrahmen (AR, AR2) nach einem der vorangehenden Ansprüche, wobei das zumindest eine Halbleiterbauelement (HB, HB2) auf einer Oberfläche (OF, OF2) des zumindest einen Anschlussrahmens (AR, AR2) angeordnet und über eine Bondverbindung (BD, BD2) mit dem Anschlusselement (PF) des zumindest einen Anschlussrahmens (AR, AR2) elektrisch verbunden ist.

8. Schaltungsanordnung (SA1) nach Anspruch 7, umfassend:
- zwei Anschlussrahmen (AR1, AR2) für jeweils mindestens ein Halbleiterbauelement (HB1, HB2), wobei die zwei Anschlussrahmen (AR1, AR2) jeweils eine Aussparung (AS1, AS2) aufweisen;
- ein elektrisch leitendendes Anschlusselement (PF) zur Herstellung einer elektrischen Verbindung zu zumindest einem der mindestens zwei Halbleiterbauelemente (HB1, HB2), das in einer der beiden Aussparungen (AS1, AS2) angeordnet ist;
- ein Isolierelement (IS1), das in den beiden Aussparungen (AS1, AS2) angeordnet ist und das Anschlusselement (PF) von den beiden Anschlussrahmen (AR1, AR2) elektrisch isoliert.

9. Schaltungsanordnung (SA1) nach Anspruch 8, ferner umfassend ein Einlegeelement (EE1), das in den beiden Aussparungen (AS1, AS2) angeordnet ist und die beiden Anschlussrahmen (AR1, AR2) miteinander mechanisch verbindet.

## Claims

1. Lead frame (AR, AR2) for a semiconductor component (HB), comprising:
- a recess (AS, AS2);
- an electrically conductive connecting element (PF) for establishing an electrical connection to the semiconductor component (HB, HB2) which is arranged in the recess (AS, AS2);
- an insulating element (IS, IS1) which is arranged in the recess (AS, AS2) and mechanically connects the connecting element (PF) to the lead frame (AR, AR2) and electrically insulates it from the lead frame (AR, AR2),
**characterized in that**
- the insulating element (IS) has a cylindrical cavity (HR1) in which an insertion element (EE), which connects the insulating element (IS) and the connecting element (PF) to one another mechanically, is arranged.

2. Lead frame (AR) according to Claim 2, wherein the insertion element (EE) is embodied in an electrically conductive fashion.

3. Lead frame (AR) according to Claim 1 or 2, wherein the insulating element (IS) comprises a base region (BB) which closes off the cavity (HR1) on one side and electrically insulates the connecting element (PF) from the lead frame (AR) .

4. Lead frame (AR) according to one of claims 1 to 3, wherein the insertion element (EE) encapsulates a cylindrical cavity (HR2) in which the connecting element (PF) is arranged, and is electrically and mechanically connected to the insertion element (EE).

5. Lead frame (AR) according to Claim 4, wherein the connecting element (PF) is connected to the insertion element (EE) in a positively and/or frictionally locking fashion.

6. Lead frame (AR) according to Claim 4 or 5, wherein the insertion element (EE) comprises a molded-on element (AF) which extends away from the cylindrical cavity (HR2) and has an electrically conductive contact face (KF) for establishing a bonded connection (BV) of the insertion element (EE) to the semiconductor component (HB).

7. Circuit arrangement (SA, SA1) comprising at least one semiconductor component (HB, HB2) and at least one lead frame (AR, AR2) according to one of the preceding claims, wherein the at least one semiconductor component (HB, HB2) is arranged on a surface (OF, OF2) of the at least one lead frame (AR, AR2) and is electrically connected to the connecting element (PF) of the at least one lead frame (AR, AR2) via a bonded connection (BD, BD2).

8. Circuit arrangement (SA1) according to Claim 7, comprising:
- two lead frames (AR1, AR2) for in each case at least one semiconductor component (HB1, HB2), wherein the two lead frames (AR1, AR2) each have a recess (AS1, AS2);
- an electrically conductive connecting element (PF) for establishing an electrical connection to at least one of the at least two semiconductor components (HB1, HB2) which is arranged in one of the two recesses (AS1, AS2); and
- an insulating element (IS1) which is arranged in the two recesses (AS1, AS2) and electrically insulates the connecting element (PF) from the two lead frames (AR1, AR2) .

9. Circuit arrangement (SA1) according to Claim 8, also comprising an insertion element (EE1) which is arranged in the two recesses (AS1, AS2) and connects the two lead frames (AR1, AR2) to one another mechanically.

## Revendications

1. Cadre de raccordement (AR, AR2) pour un composant semiconducteur (HB), comprenant :
- un évidement (AS, AS2) ;
- un élément de raccordement (PF) électriquement conducteur destiné à établir une liaison électrique avec le composant semiconducteur (HB, HB2), qui est disposé dans l'évidement (AS, AS2) ;
- un élément isolant (IS, IS1) qui est disposé dans l'évidement (AS, AS2) et qui relie mécaniquement l'élément de raccordement (PF) au cadre de raccordement (AR, AR2) et l'isole électriquement du cadre de raccordement (AR, AR2),
**caractérisé en ce que**
- l'élément isolant (IS) possède un espace creux (HR1) de forme cylindrique dans lequel est disposé un élément d'insertion (EE) qui relie mécaniquement entre eux l'élément isolant (IS) et l'élément de raccordement (PF).

2. Cadre de raccordement (AR) selon la revendication 1, l'élément d'insertion (EE) étant réalisé de manière électriquement conductrice.

3. Cadre de raccordement (AR) selon la revendication 1 ou 2, l'élément isolant (IS) comprenant une zone de fond (BB) qui ferme unilatéralement l'espace creux (HR1) et isole électriquement l'élément de raccordement (PF) du cadre de raccordement (AR).

4. Cadre de raccordement (AR) selon l'une des revendications 1 à 3, l'élément d'insertion (EE) enveloppant un espace creux (HR2) de forme cylindrique dans lequel l'élément de raccordement (PF) est disposé et est relié électriquement et mécaniquement avec l'élément d'insertion (EE).

5. Cadre de raccordement (AR) selon la revendication 4, l'élément de raccordement (PF) étant relié à l'élément d'insertion (EE) par complémentarité de formes et/ou par assemblage de force.

6. Cadre de raccordement (AR) selon la revendication 4 ou 5, l'élément d'insertion (EE) comprenant un surmoulage (AF) qui s'étend en s'éloignant de l'espace creux (HR2) de forme cylindrique, pourvu d'une surface de contact (KF) électriquement conductrice destinée à établir une liaison de connexion (BV) de l'élément d'insertion (EE) au composant semiconducteur (HB).

7. Arrangement de circuit (SA, SA1) comprenant au moins un composant semiconducteur (HB, HB2) et au moins un cadre de raccordement (AR, AR2) selon l'une des revendications précédentes, l'au moins un composant semiconducteur (HB, HB2) étant disposé sur une surface (OF, OF2) de l'au moins un cadre de raccordement (AR, AR2) et étant relié électriquement à l'élément de raccordement (PF) de l'au moins un cadre de raccordement (AR, AR2) par le biais d'une liaison de connexion (BD, BD2).

8. Arrangement de circuit (SA1) selon la revendication 7, comprenant :
- deux cadres de raccordement (AR1, AR2) respectivement pour au moins un composant semiconducteur (HB1, HB2), les deux cadres de raccordement (AR1, AR2) possédant respectivement un évidement (AS1, AS2) ;
- un élément de raccordement (PF) électriquement conducteur destiné à établir une liaison électrique avec au moins l'un des au moins deux composants semiconducteurs (HB1, HB2), qui est disposé dans l'un des deux évidements (AS1, AS2) ;
- un élément isolant (IS1) qui est disposé dans les deux évidements (AS1, AS2) et qui isole électriquement l'élément de raccordement (PF) des deux cadres de raccordement (AR1, AR2).

9. Arrangement de circuit (SA1) selon la revendication 8, comprenant en outre un élément d'insertion (EE1) qui est disposé dans les deux évidements (AS1, AS2) et qui relie mécaniquement entre eux les deux cadres de raccordement (AR1, AR2).
